# FASCICULE DE BREVET EUROPEEN

(11) **EP 4 484 941 B1**
(45) Date de publication et mention de la délivrance du brevet: **19.08.2026**
(21) Numéro de dépôt: 24184637.7
(22) Date de dépôt: 26.06.2024
(51) Int. Cl.: G01N 27/04, H05K 1/02

(54) **DÉTECTION D'HUMIDITÉ PAR MESURE D'IMPÉDANCE ENTRE DEUX PISTES**
FEUCHTIGKEITSERFASSUNG DURCH IMPEDANZMESSUNG ZWISCHEN ZWEI SPUREN
MOISTURE DETECTION BY MEASURING IMPEDANCE BETWEEN TWO TRACKS

(30) Priorité: 30.06.2023 FR 2306944
(43) Date de publication de la demande: 01.01.2025
(73) Titulaire: SAGEMCOM ENERGY & TELECOM SAS, 92270 Bois-Colombes (FR)
(72) Inventeur: SABRAOUI, Abbas, 92270 Bois-Colombes (FR); WEBER, Patrick, 92270 Bois-Colombes (FR)
(74) Mandataire: Cabinet Boettcher

(56) Documents cités:
- WO-A1-2023/042940
- US-A- 4 598 333
- US-A- 5 606 264
- US-A1- 2021 059 055
- US-A1- 2023 204 652
- US-B2- 11 209 377
- US-B2- 11 536 646
- US-B2- 8 823 535

## Description

L'invention concerne le domaine de la détection d'humidité sur les cartes électroniques.

### ARRIERE PLAN DE L'INVENTION

Il existe un certain nombre de causes susceptibles de provoquer un niveau d'humidité trop élevé sur une carte électronique.

L'une de ces causes est la suivante. Dans le cas d'une carte électronique enduite ou surmoulée, lorsque la résine n'est pas correctement débullée (processus nécessaire pour éliminer toutes les bulles d'air avant la polymérisation), les bulles peuvent rester bloquées près des composants électroniques de la carte. Les variations de température peuvent alors provoquer de la condensation, entraînant un risque important de court-circuit et de corrosion.

Il est connu, pour évaluer le niveau d'humidité sur une carte, d'utiliser un capteur d'humidité. On utilise ainsi fréquemment un capteur capacitif intégré dans un boîtier CMS (pour *Composant Monté en Surface*) pour mesurer l'humidité.

Ce type de capteur pose le problème suivant. La performance du capteur est limitée lorsqu'il est soudé sur une carte électronique recouverte de résine (comme une résine souple) ou de vernis, car la résine ou le vernis obstrue le capteur et réduit la fiabilité des mesures.

Par ailleurs, la consommation électrique de ce type de capteur est relativement élevée, ce qui peut être un inconvénient pour certaines applications. Dans les compteurs de fluide par exemple (eau, gaz, etc.), les fonctions électroniques sont généralement alimentées par une pile ou une batterie, et il est donc crucial de limiter au maximum la consommation desdites fonctions.

US 45 98 333 et US 88 23 535 divulguent des dispositifs de détection d'humidité sur un circuit imprimé à partir d'une mesure de courant entre deux pistes conductrices imprimées sur le circuit.

### OBJET DE L'INVENTION

L'invention a pour objet d'améliorer l'efficacité de la détection d'humidité sur ou dans un circuit imprimé, tout en réduisant la consommation électrique nécessitée par cette détection.

### RESUME DE L'INVENTION

En vue de la réalisation de ce but, on propose un dispositif de surveillance de l'humidité sur un circuit imprimé, selon la revendication 1.

Le dispositif de surveillance est capable de détecter la présence d'humidité sur le circuit imprimé, même lorsque celui-ci est recouvert de résine ou de vernis.

Le dispositif de surveillance est extrêmement simple à réaliser et très peu coûteux, puisque ce sont des pistes conductrices imprimées sur le circuit imprimé qui jouent le rôle de capteur. La consommation électrique du dispositif de surveillance est très faible.

On propose de plus un dispositif de surveillance tel que précédemment décrit, dans lequel la tension de test est une tension continue.

On propose de plus un dispositif de surveillance tel que précédemment décrit, dans lequel la première portion de piste et la deuxième portion de piste sont recouvertes d'un revêtement de protection destiné à empêcher un matériau principal, avec lequel sont fabriquées la première piste conductrice et la deuxième piste conductrice, de se corroder.

On propose de plus un dispositif de surveillance tel que précédemment décrit, le revêtement de protection étant en or-nickel.

On propose de plus un dispositif de surveillance tel que précédemment décrit, dans lequel la première piste conductrice et la deuxième piste conductrice forment deux électrodes en forme de boucle.

On propose de plus un dispositif de surveillance tel que précédemment décrit, dans lequel la première piste conductrice et la deuxième piste conductrice forment deux électrodes interdigitées.

On propose de plus un dispositif de surveillance tel que précédemment décrit, dans lequel :
- la première piste conductrice est connectée à au moins une première castellation formée dans une épaisseur du circuit imprimé, et
- la deuxième piste conductrice est connectée à au moins une deuxième castellation formée dans l'épaisseur du circuit imprimé,
la tension de test étant appliquée sur la première piste conductrice et la tension cible étant mesurée sur la deuxième piste conductrice.

On propose de plus un dispositif de surveillance tel que précédemment décrit, dans lequel la première piste conductrice comporte deux premiers tronçons connectés entre eux, perpendiculaires entre eux et connectant chacun deux premières castellations entre elles, et la deuxième piste conductrice comporte deux deuxièmes tronçons connectés entre eux, perpendiculaires entre eux et connectant chacun deux deuxièmes castellations entre elles.

On propose de plus un dispositif de surveillance tel que précédemment décrit, dans lequel la première piste conductrice et la deuxième piste conductrice sont situées sur une même couche du circuit imprimé.

On propose de plus un dispositif de surveillance tel que précédemment décrit, dans lequel ladite couche est une couche interne du circuit imprimé.

On propose de plus un dispositif de surveillance tel que précédemment décrit, comprenant une première piste conductrice et une deuxième piste conductrice situées sur une première couche du circuit imprimée, et une autre première piste conductrice et une autre deuxième piste conductrice situées sur une deuxième couche du circuit imprimée, les premières pistes conductrices étant connectées entre elles par au moins un premier via traversant et les deuxièmes pistes conductrices étant connectées entre elles par au moins un deuxième via traversant.

On propose de plus un dispositif de surveillance tel que précédemment décrit, comprenant plusieurs premières pistes conductrices connectées en série et plusieurs deuxièmes pistes conductrices connectées en série.

On propose de plus un dispositif de surveillance tel que précédemment décrit, comprenant plusieurs premières pistes conductrices connectées en parallèle et plusieurs deuxièmes pistes conductrices connectées en parallèle.

On propose de plus un dispositif de surveillance tel que précédemment décrit, dans lequel la première piste conductrice et/ou la deuxième piste conductrice sont utilisées aussi pour transporter des signaux utilisés pour une autre fonction, la détection du niveau d'humidité trop élevé étant réalisée par le dispositif de surveillance lorsque ladite autre fonction est inactive.

On propose de plus un dispositif de surveillance tel que précédemment décrit, dans lequel des composants électriques sont montés sur le circuit imprimé, ces composants électrique comportant un composant le plus sensible à l'humidité, le composant le plus sensible à l'humidité étant positionné dans une zone entourée par la première piste conductrice et la deuxième piste conductrice.

On propose de plus un dispositif de surveillance tel que précédemment décrit, comprenant un comparateur analogique et une source de tension, la tension cible étant comparée par le comparateur analogique avec une tension de référence produite par la source de tension, le seuil prédéterminé étant ainsi un seuil analogique.

On propose de plus un procédé de détection, mis en œuvre dans un dispositif de surveillance tel que précédemment décrit, comprenant les étapes de :
- appliquer une tension de test sur l'une des première piste conductrice et deuxième piste conductrice, l'autre des première piste conductrice et deuxième piste conductrice étant connectée à une référence de tension constante ou contrôlée ;
- comparer une tension cible, représentative d'une impédance entre la première piste conductrice et la deuxième piste conductrice, avec un seuil prédéterminé, ladite impédance étant réduite en présence d'humidité ;
- détecter un niveau d'humidité trop élevé sur ou dans le circuit imprimé, entre la première piste conductrice et la deuxième piste conductrice, en fonction d'un résultat de ladite comparaison.

On propose de plus un programme d'ordinateur comprenant des instructions qui conduisent le dispositif de test du dispositif de surveillance tel que précédemment décrit à exécuter les étapes du procédé de détection tel que précédemment décrit.

On propose de plus un support d'enregistrement lisible par ordinateur, sur lequel est enregistré le programme d'ordinateur tel que précédemment décrit.

L'invention sera mieux comprise à la lumière de la description qui suit de modes de mise en œuvre particuliers non limitatifs de l'invention.

### BREVE DESCRIPTION DES DESSINS

Il sera fait référence aux dessins annexés parmi lesquels :
[Fig. 1] la figure 1 est une vue en coupe d'une portion de circuit imprimé selon un premier mode de réalisation, selon un plan perpendiculaire audit circuit imprimé ;
[Fig. 2] la figure 2 représente la première piste conductrice et la deuxième piste conductrice formant des électrodes en forme de boucle, ainsi qu'un dispositif de test selon un premier mode de réalisation ;
[Fig. 3] la figure 3 représente la première piste et la deuxième piste formant des électrodes interdigitées ;
[Fig. 4] la figure 4 représente la première piste conductrice et la deuxième piste conductrice formant des électrodes selon une configuration de castellation ;
[Fig. 5] la figure 5 représente la première piste conductrice et la deuxième piste conductrice formant des électrodes en forme de boucle, ainsi qu'un dispositif de test selon un deuxième mode de réalisation ;
[Fig. 6] la figure 6 représente la première piste conductrice et la deuxième piste conductrice formant des électrodes en forme de boucle, ainsi qu'un dispositif de test selon un troisième mode de réalisation ;
[Fig. 7] la figure 7 représente la première piste conductrice et la deuxième piste conductrice formant des électrodes en forme de boucle, ainsi qu'un dispositif de test selon un quatrième mode de réalisation ;
[Fig. 8] la figure 8 représente les étapes d'un procédé de détection ;
[Fig. 9] la figure 9 est une vue en coupe d'une portion de circuit imprimé selon un deuxième mode de réalisation, selon un plan perpendiculaire audit circuit imprimé.

### DESCRIPTION DETAILLEE DE L'INVENTION

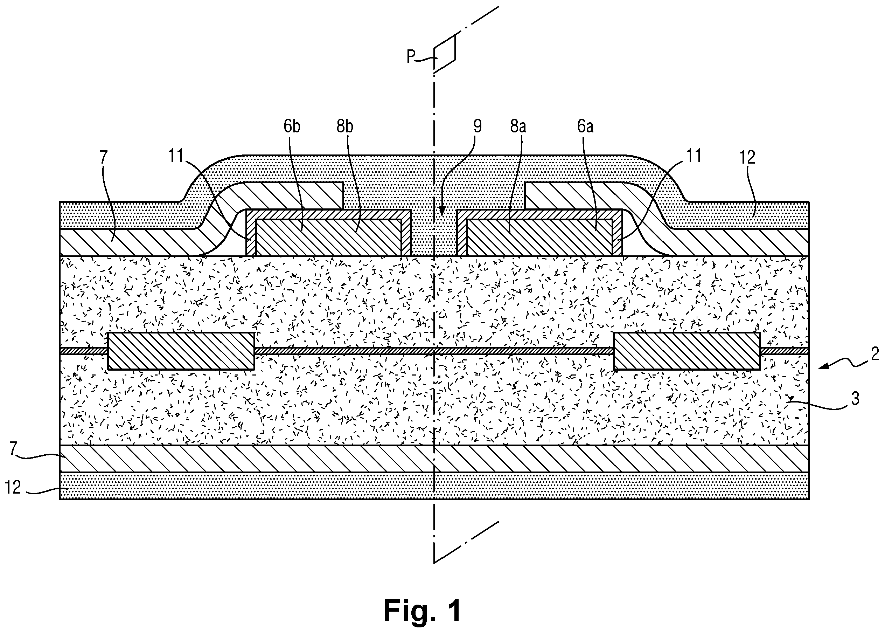

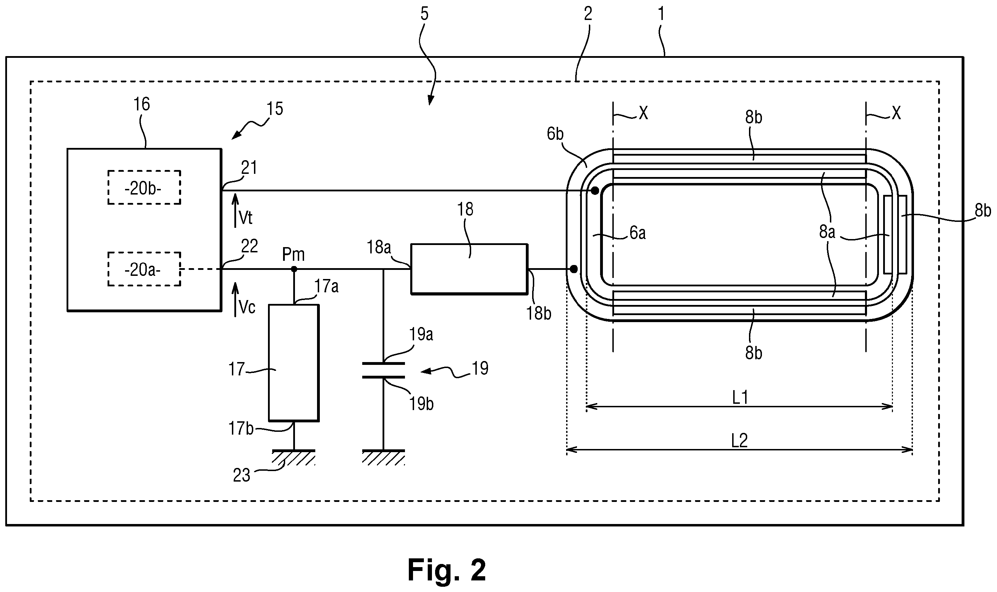

En référence aux figures 1 et 2, un compteur d'eau 1 comporte une carte électronique 2 comprenant un circuit imprimé 3 sur lequel sont montés des composants électroniques.

Les composants électroniques comprennent des composants réalisant une ou des fonctions diverses mises en œuvre dans un compteur d'eau : fonctions de métrologie (mesure de la consommation d'eau), de communication (transmission des mesures de consommation, interface avec l'utilisateur), de surveillance (détection de fuite, de dysfonctionnement du compteur, de tentative de fraude), d'alimentation électrique des composants de la carte électronique, etc.

Le compteur d'eau 1 comprend un dispositif de surveillance 5 du niveau d'humidité régnant sur le circuit imprimé 3.

Le dispositif de surveillance 5 comprend une première piste conductrice 6a (de cuivre par exemple) et une deuxième piste conductrice 6b (de cuivre par exemple) imprimées ici sur une même couche (couche supérieure) du circuit imprimé 3. La première piste 6a et la deuxième piste 6b ne sont pas connectées entre elles.

La première piste 6a et la deuxième piste 6b forment deux électrodes, ici chacune en forme de boucle. La première électrode forme donc une première boucle et la deuxième électrode forme une deuxième boucle. Chaque boucle a la forme d'un rectangle aux coins arrondis.

La première piste 6a et la deuxième piste 6b sont disposées de sorte que la deuxième piste 6b entoure la première piste 6a.

La première piste 6a est donc située à l'intérieur de la deuxième boucle formée par la deuxième piste 6b.

La première piste 6a et la deuxième piste 6b ont la même forme, mais les dimensions de la deuxième pistes 6a sont légèrement inférieures à celles de la première piste 6b. La deuxième piste 6b longe la première piste 6a sur la totalité de leur longueur.

La première piste 6a et la deuxième piste 6b sont très proches : chaque point de la première piste 6a est situé à une distance d'un point le plus proche de la deuxième piste 6b, qui est comprise entre 1% et 10% d'une plus grande dimension de la forme de la première électrode et/ou de la deuxième électrode.

Ici, la plus grande dimension de la première électrode est la longueur L1, et la plus grande dimension de la deuxième électrode est la longueur L2.

Le circuit imprimé 1 est recouvert de vernis épargne 7 sur une grande partie de ses couches externes (supérieure et inférieure).

La première piste 6a comprend (au moins) une première portion de piste 8a, qui n'est pas recouverte de vernis épargne, et la deuxième piste 6b comprend (au moins) une deuxième portion de piste 8b, qui n'est pas recouverte de vernis épargne.

Ici, la première piste 6a comprend trois premières portions de piste 8a non recouvertes de vernis épargne et la deuxième piste 6b comprend trois deuxièmes portions de piste 8b non recouvertes de vernis épargne.

Pour la première piste 6a, les premières portions de piste 8a sont situées sur un premier côté (longueur) de la première boucle, sur un deuxième côté (largeur) de la première boucle, et sur un troisième côté (longueur) de la première boucle.

De même, pour la deuxième piste 6b, les deuxièmes portions de piste 8b sont situées sur un premier côté (longueur) de la deuxième boucle, sur un deuxième côté (largeur) de la deuxième boucle, et sur un troisième côté (longueur) de la deuxième boucle.

Chaque première portion de piste 8a est associée à une deuxième portion de piste 8b. La première portion de piste 8a s'étend sur un premier segment de la première piste 6a. La deuxième portion de piste 8b s'étend sur un deuxième segment de la deuxième piste 6b.

Le premier segment et le deuxième segment se longent sur le circuit imprimé 3, sont sensiblement parallèles (c'est-à-dire qu'ils s'étendent sensiblement selon une même direction sans contact électrique), ont sensiblement la même longueur (éventuellement avec une petite différence, de l'ordre du mm par exemple), et ont leurs extrémités sensiblement alignées selon des axes X perpendiculaires auxdits segments (éventuellement avec un petit écart, de l'ordre du mm par exemple) .

Les premières portions de piste 8a et les deuxièmes portions de pistes 8b sont définies dans des zones dans lesquelles la première piste 6a et la deuxième piste 6b présentent des dimensions parfaitement maîtrisées en fabrication.

Chaque première portion de piste 8a est donc définie sur un premier segment de la première piste 6a. La première portion de piste 8a est définie sur toute la longueur et sur une partie interne de la largeur du premier segment. De même, chaque deuxième portion de piste 8b est définie sur un deuxième segment de la deuxième piste 6b. La deuxième portion de piste 8b est définie sur toute la longueur et sur une partie interne de la largeur du deuxième segment.

Par « interne », on entend du côté d'un plan P (visible sur la figure 1) perpendiculaire au circuit imprimé 1, situé entre la première portion de piste 8a et la deuxième portion de piste 8b associée et parallèle à celles-ci ; la première portion de piste 8a et la deuxième portion de piste 8b sont donc disposées en regard l'une de l'autre et symétriquement par rapport au plan P.

La surface 9 du circuit imprimé 1 située entre chaque première portion de piste 8a et la deuxième portion de piste 8b associée n'est pas non plus recouverte de vernis épargne.

Par contre, la totalité de la surface de chacune des première portion de piste 8a et deuxième portion de piste 8b est ici recouverte par un revêtement de protection 11, qui est préférentiellement en or-nickel.

Le revêtement est destiné à empêcher un matériau principal, avec lequel sont fabriquées la première piste 6a et la deuxième piste 6b, de se corroder.

Les bords latéraux de chacune des premières portions de piste 8a et deuxièmes portions de piste 8b sont aussi recouverts de ce revêtement de protection 11.

On note de plus qu'ici, la totalité du circuit imprimé 1 est recouverte d'une résine 12 (qui recouvre donc aussi les premières et deuxièmes portions de piste 8a, 8b, non recouvertes de vernis épargne).

Le dispositif de surveillance 5 comprend de plus un dispositif de test 15.

Ici, le dispositif de test 15 comprend des composants électroniques qui sont montés sur le circuit imprimé 1 (mais ils pourraient être positionnés sur une autre carte).

Le dispositif de test 15 :
∘ applique une tension de test Vt sur la première piste 6a (éventuellement via un ou des composants), la deuxième piste 6b étant connectée à une référence de tension constante ou contrôlée ;
∘ compare une tension cible Vc, représentative d'une impédance entre la première piste 6a et la deuxième piste 6b, avec un seuil prédéterminé, ladite impédance étant réduite en présence d'humidité ;
∘ détecte un niveau d'humidité trop élevé sur ou dans le circuit imprimé 1, entre la première piste 6a et la deuxième piste 6b, en fonction d'un résultat de ladite comparaison.

La référence de tension constante ou contrôlée, à laquelle est connectée la deuxième piste, est ici une masse électrique 23. La deuxième piste est connectée à cette masse électrique 23 via des composants passifs (17, 18, 19) décrits plus bas.

La tension de test Vt est ici une tension continue, et l'impédance est une impédance en courant continu. L'impédance entre la première piste 6a et la deuxième piste 6b dépend des fuites de courant dues à la présence d'humidité.

Le dispositif de test 15 comprend ici un microcontrôleur 16, une résistance 17, une inductance 18 et un condensateur 19.

Le microcontrôleur 16 intègre un convertisseur analogique numérique (CAN) 20a. Le dispositif de test 15 comprend aussi une ou des mémoires 20b, reliées à ou intégrées dans le microcontrôleur 16. Au moins l'une de ces mémoires 20b forme un support d'enregistrement lisible par ordinateur, sur lequel est enregistré au moins un programme d'ordinateur comprenant des instructions qui conduisent le microcontrôleur 16 à exécuter au moins certaines des étapes du procédé de détection qui sera décrit plus bas.

Le microcontrôleur 16 a une sortie 21 (sortie CTRL), et une entrée 22 qui est connectée à son CAN 20a.

La sortie 21 est connectée à la première piste 6a directement. L'entrée 22 est connectée à la deuxième piste 6b via la résistance 17, l'inductance 18 et le condensateur 19. L'inductance 18 pourrait être elle-même remplacée par une résistance.

La résistance 17 a une borne 17a connectée à l'entrée 22 et une borne 17b connectée à la masse électrique 23 de la carte électronique 2.

La résistance 17 présente une bonne robustesse à l'humidité et a une valeur de résistance élevée, par exemple égale à 10 MΩ.

Le condensateur 19 a lui aussi une borne 19a connectée à l'entrée 22 et une borne 19b connectée à la masse électrique 23.

Le condensateur 19 et la résistance 17 sont donc montées en parallèle.

Le condensateur 19 est optionnel. Le condensateur 19 est par exemple un condensateur céramique, qui présente une bonne robustesse à l'humidité. Le condensateur 19 a par exemple une valeur de capacité égale à 100 nF.

L'inductance (ou la résistance) 18 a une borne 18a connectée à l'entrée 22, à la borne 17a de la résistance 17 et à la borne 19a du condensateur 19, et une borne 18b connectée à la deuxième piste 6b.

L'inductance (ou la résistance) 18 est optionnelle. L'inductance (ou la résistance) 18 est par exemple une inductance multicouche, qui présente une bonne robustesse à l'humidité. L'inductance 18 a par exemple une valeur d'inductance égale à 22 nH.

Pour réaliser la détection d'humidité, le microcontrôleur 16 polarise la première électrode en appliquant sur la première piste 6a la tension de test Vt, qui est ici une tension continue égale à 3,3 V (qui est aussi la tension d'alimentation Vcc du microcontrôleur 16).

Le CAN 20a numérise alors la tension cible Vc présente à l'entrée 22 du microcontrôleur 16, qui dépend de l'impédance entre la première piste 6a et la deuxième piste 6b. La tension cible Vc est mesurée en un point de mesure connecté à la deuxième piste 6b via l'inductance (ou la résistance) 18, la résistance 17 et le condensateur 19.

Plus la tension cible Vc est élevée, plus l'impédance est élevée, et donc plus le niveau d'humidité est important.

Le microcontrôleur 16 compare donc la tension cible Vc avec un seuil prédéterminé, et détecte un niveau d'humidité trop élevé sur le circuit imprimé 1, entre la première piste 6a et la deuxième piste 6b, en fonction d'un résultat de ladite comparaison. Le microcontrôleur 16 détecte un niveau d'humidité trop élevé si la tension cible Vc est supérieure (ici strictement) au seuil prédéterminé.

Le seuil prédéterminé est par exemple égal à 200mV.

L'humidité détectée peut être présente soit sur la surface du circuit imprimé 1 entre les deux pistes 6a, 6b, dans la résine 12, ou dans l'épaisseur du circuit imprimé 3 (c'est-à-dire dans le matériau isolant du circuit imprimé).

On note que l'absence de vernis épargne sur la première portion de piste 8a et la deuxième portion de piste 8b permet de mieux capter les courants de fuite.

En présence d'humidité, des courants de fuite de l'ordre de 10 nA sont mesurables.

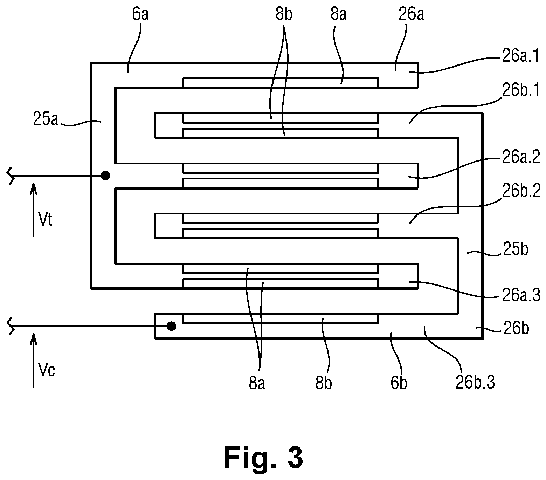

En référence à la figure 3, dans un mode de réalisation alternatif, la première piste 6a et la deuxième piste 6b forment deux électrodes interdigitées.

Les électrodes interdigitées sont une configuration particulière d'électrodes largement utilisée dans les dispositifs électrochimiques, tels que les capteurs de gaz, les capteurs de pH, les capteurs de glucose, etc. Une électrode interdigitée consiste en une série d'électrodes métalliques parallèles disposées de manière alternée et interconnectées à des régions électriques distinctes. La structure interdigitée permet d'augmenter la longueur (et la surface) d'électrode active.

La première piste 6a comprend ici une première base 25a et trois premiers doigts 26a perpendiculaires à la première base 25a. La deuxième piste 6b comprend ici une deuxième base 25b et trois deuxièmes doigts 26b perpendiculaires à la deuxième base 25b.

Les premiers doigts 26a les deuxièmes doigts 26b sont disposés de manière alternée en étant parallèles entre eux.

Chaque premier doigt 26a comprend au moins une première portion de piste 8a qui n'est pas recouverte de vernis épargne, et chaque deuxième doigt 26b comprend au moins une deuxième portion de piste 8b qui n'est pas recouverte de vernis épargne.

Ici, le premier doigt 26a.1 comprend une seule première portion de piste 8a, alors que le premier doigt 26a.2 et le premier doigt 26a.3 comprennent chacun deux premières portions de piste 8a.

De même, le deuxième doigt 26b.3 comprend une seule deuxième portion de piste 8b, alors que le deuxième doigt 26b.1 et le deuxième doigt 26b.2 comprennent chacun deux deuxièmes portions de piste 8a.

Les premières portions de piste 8a et deuxièmes portions de piste 8b sont semblables à celles précédemment décrites.

La tension de test Vt est appliquée sur un point central de la première base 25a (au niveau d'une extrémité du premier doigt central), éventuellement via un ou des composants, et la tension cible Vc est mesurée au niveau d'une extrémité libre du deuxième doigt du bas 26b (sur la figure), éventuellement via un ou des composants.

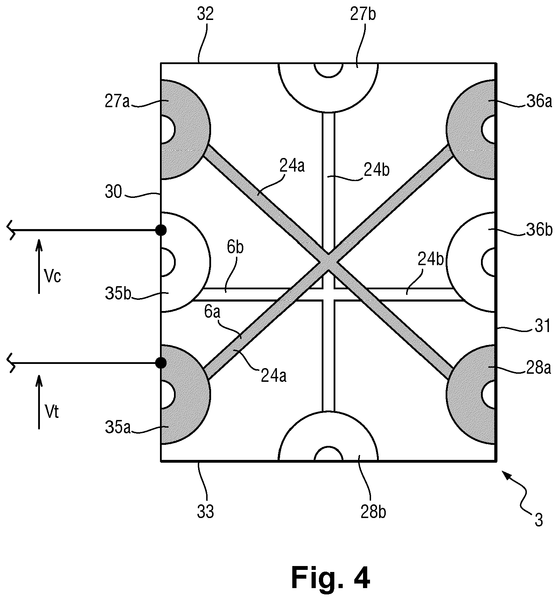

En référence à la figure 4, dans un mode de réalisation alternatif, la première piste 6a et la deuxième piste 6b forment des électrodes arrangées selon une configuration en castellation.

La castellation est une configuration d'électrodes utilisée dans les dispositifs à semi-conducteurs tels que les puces à technologie CMOS (pour *Complementary Metal-Oxide-Semiconductor*) ou les capteurs d'images. Elle consiste en une série de couches métalliques superposées avec des ouvertures en forme de marches ou de créneaux, créant ainsi une structure en escalier. Cette configuration permet de réaliser des connexions verticales entre différentes couches de circuits intégrés, facilitant ainsi l'intégration et l'interconnexion de composants.

La première piste 6a est connectée à au moins une première castellation, formée dans une épaisseur du circuit imprimé 3.

La deuxième piste 6b est connectée à au moins une deuxième castellation, formée dans l'épaisseur du circuit imprimé.

La tension de test est appliquée sur la première piste conductrice et la tension cible est mesurée sur la deuxième piste conductrice.

La première piste 6a comprend ici en l'occurrence un premier tronçon 24a qui connecte entre elles deux premières castellations 35a, 36a, et un premier tronçon 24a qui connecte entre elles deux premières castellation 27a, 28a. Les deux premiers tronçons 24a sont connectés entre eux et sont ici perpendiculaires entre eux. La deuxième piste 6b comprend un deuxième tronçon 24b qui connecte entre elles deux deuxièmes castellations 35b, 36b, et un deuxième tronçon 24b qui connecte entre elles deux deuxièmes castellations 27b, 28b. Les deux deuxièmes tronçons 24b sont connectés entre eux et sont ici perpendiculaires entre eux.

La deuxième castellation 35b est positionnée au niveau d'un premier bord 30 du circuit imprimé 3 entre la première castellation 35a et la première castellation 27a (au milieu) . De même, la deuxième castellation 36b est positionnée au niveau d'un premier bord 31 (opposé au premier bord) du circuit imprimé 3 entre la première castellation 36a et la première castellation 28a (au milieu).

La deuxième castellation 27b est positionnée au milieu d'un troisième bord 32 (perpendiculaire au premier bord 30 et au deuxième bord 31), et la deuxième castellation 28b est positionnée au milieu d'un quatrième bord 33 (opposé au troisième bord 32). Les premiers tronçons 24a forment sensiblement des diagonales du circuit imprimé 3.

La tension de test Vt est appliquée sur la première castellation 35a (et donc sur la première piste), éventuellement via un ou des composants, et la tension cible Vc est mesurée sur la deuxième castellation 35b (et donc sur la deuxième piste), éventuellement via un ou des composants.

Les castellations sont formées dans l'épaisseur du circuit imprimé 3.

Les castellations sont formées par exemple en réalisant tout d'abord des vias traversants (ou PTH pour *Plated Through Hole*) dans le circuit imprimé 3, puis en découpant (par fraisage par exemple) le circuit imprimé 3 de manière à laisser une moitié de chaque via traversant dans la tranche du bord du circuit imprimé.

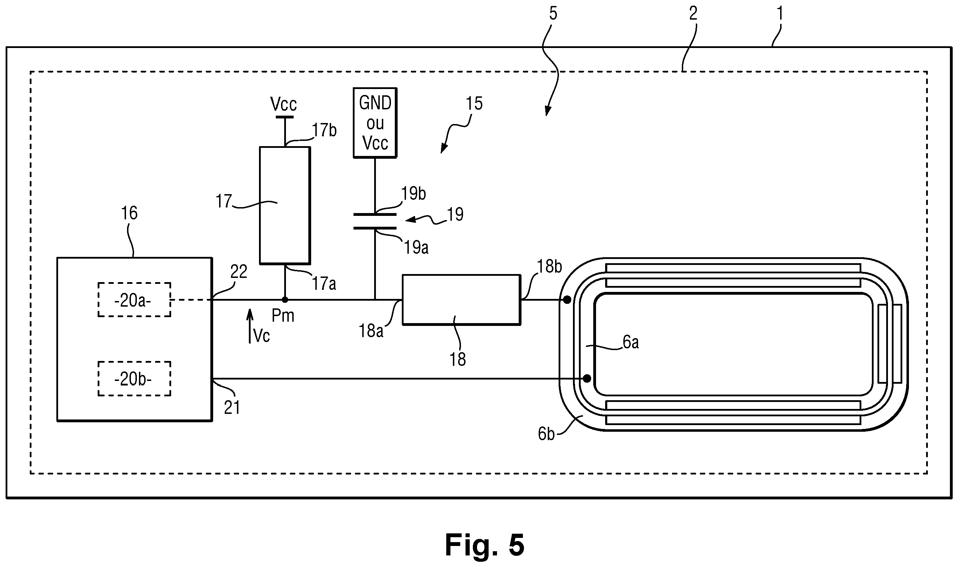

On décrit maintenant, en référence à la figure 5, un deuxième mode de réalisation du dispositif de test 15.

La sortie 21 du microcontrôleur 16 est directement connectée à la première piste 6a.

L'entrée 22 du microcontrôleur 16 (qui est connectée au CAN 20a) est connectée à la deuxième piste 6b via la résistance 17, l'inductance (ou la résistance) 18 et le condensateur 19.

L'inductance (ou la résistance) 18 a une borne 18a connectée à l'entrée 22 et une borne 18b connectée à la deuxième piste 6b.

Le condensateur 19 a une borne 19a connectée à l'entrée 22 et à la borne 18a de l'inductance (ou la résistance) 18, et une borne 19b connectée à la masse 23 (GND), à l'alimentation (Vcc) ou à tout autre référence de tension de la carte électronique 2.

La résistance 17 a une borne 17a connectée à l'entrée 22, à la borne 18a de l'inductance (ou de la résistance) 18 et à la borne 19a du condensateur 19, et une borne 17b connectée à l'alimentation Vcc.

Le condensateur 19 et la résistance 17 sont donc montées en parallèle.

L'activation du dispositif se fait cette fois en amenant la première piste 6a à la masse électrique (le signal CTRL du microcontrôleur 16, qui active la mesure, est actif à la masse) .

La tension de test est donc cette fois la tension Vcc.

La tension cible Vc est mesurée en un point de mesure Pm connecté à la deuxième piste 6b par l'inductance 18.

Le microcontrôleur 16 détecte un niveau d'humidité trop élevé si la tension cible Vc est inférieure (ici inférieure ou égale) au seuil prédéterminé.

A nouveau, le condensateur 19 et l'inductance (ou la résistance) 18 sont optionnels.

On a donc inversé la mesure électrique en la référençant à l'alimentation plutôt qu'à la masse.

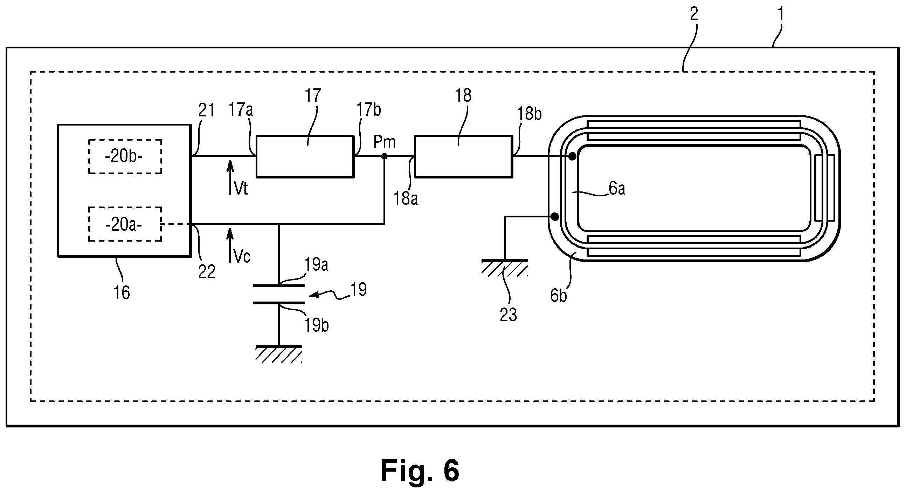

On décrit maintenant, en référence à la figure 6, un troisième mode de réalisation du dispositif de test 15.

Cette fois, la sortie 21 du microcontrôleur 16 est connectée à la première piste 6a via la résistance 17 et l'inductance (ou la résistance) 18, qui sont montées en série. La borne 17a de la résistance 17 est connectée à la sortie 21. La borne 17b de la résistance 17 est connectée à la borne 18a de l'inductance (ou la résistance) 18. La borne 18b de l'inductance (ou la résistance) 18 est connectée à la première piste 6a.

L'entrée 22 du microcontrôleur 16 (qui est connectée au CAN 20a) est connectée à un point de mesure Pm situé entre la borne 17b de la résistance 17 et la borne 18a de l'inductance 18.

La borne 19a du condensateur est connectée à l'entrée 22 et au point de mesure Pm. La borne 19b du condensateur 19 est connectée à la masse électrique 23.

La deuxième piste 6b est connectée à la masse électrique 23.

La tension cible Vc est donc mesurée en un point de mesure Pm connecté à la deuxième piste 6b par l'inductance 18.

Le microcontrôleur 16 détecte un niveau d'humidité trop élevé si la tension cible Vc est inférieure (ici inférieure ou égale) au seuil prédéterminé.

A nouveau, le condensateur 19 et l'inductance (ou la résistance) 18 sont optionnels.

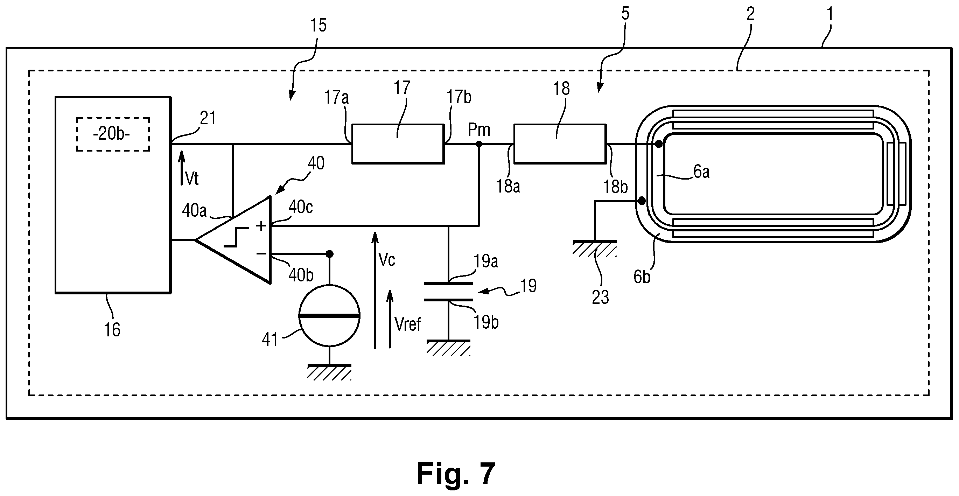

On décrit maintenant, en référence à la figure 7, un quatrième mode de réalisation du dispositif de test 15.

La détection par le CAN est remplacée par une détection par un comparateur avec seuil 40. Le comparateur est un comparateur analogique.

Le dispositif de test 15 comprend cette fois une source de tension 41 (générant une tension de référence Vref, égale ici à 1,2V) et le comparateur 40.

La sortie 21 du microcontrôleur 16 est connectée à la première piste 6a via la résistance 17 et l'inductance 18, qui sont donc montées en série. La borne 17a de la résistance 17 est connectée à la sortie 21. La borne 17b de la résistance 17 est connectée à la borne 18a de l'inductance 18. La borne 18b de l'inductance 18 est connectée à la première piste 6a.

La sortie 21 du microcontrôleur 16 est aussi connectée à un port d'alimentation 40a du comparateur 40 (qui est donc alimenté par la tension de test Vt.

La source de tension 41 est connectée entre l'entrée négative 40b du comparateur 40 et la masse électrique 23, de sorte que la tension de référence Vref est appliquée sur cette entrée négative 40b.

La borne 19a du condensateur 19 est connectée à l'entrée positive 40c du comparateur 40. La borne 19b du condensateur est connectée à la masse 23.

L'entrée positive 40c du comparateur 40 est connecté à un point de mesure Pm située entre la résistance 17 et l'inductance 18 (et donc à la borne 17b de la résistance 17, à la borne 18a de l'inductance 18 et à la borne 19a du condensateur 19).

Le comparateur 40 compare donc la tension cible Vc avec une tension de référence Vref produite par la source de référence 41. Lorsque la tension cible Vc est inférieure à la tension de référence Vref, le microcontrôleur 16 détecte un niveau d'humidité trop élevé.

Le seuil prédéterminé, avec lequel la tension cible est comparée, est donc ici un seuil analogique.

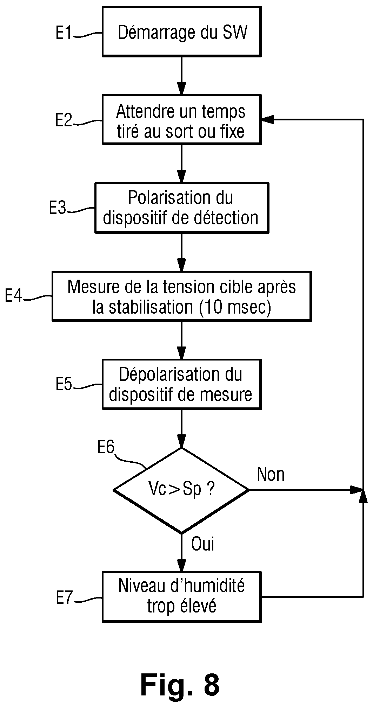

On décrit maintenant, en référence à la figure 8, un procédé de détection, qui est ici mis en œuvre par le microcontrôleur 16. Le procédé est répété périodiquement.

Le microcontrôleur 16 démarre le logiciel de test : étape E1.

Le microcontrôleur 16 attend un temps d'attente. Le temps d'attente a une durée prédéterminée (égale par exemple à 500 s, ou bien une durée aléatoire et tirée au sort (et comprise possiblement entre une borne minimum, égale par exemple à 1 s, et une borne maximum, égale par exemple à 1000 s) : étape E2.

Le microcontrôleur 16 applique la tension de test sur la première piste 6a et polarise ainsi le dispositif de surveillance 5 : étape E3.

Le microcontrôleur 16 attend une certaine durée que la tension cible Vc se stabilise (10 ms typiquement), puis mesure la tension cible Vc : étape E4.

Le microcontrôleur dépolarise alors le dispositif de surveillance 5 : étape E5.

Le microcontrôleur 16 compare la tension cible Vc avec le seuil prédéterminé Sp (200 mV par exemple) : étape E6. On note que ce seuil prédéterminé Sp peut être configurable. La valeur du seuil pourrait par exemple être choisie en fonction de la sensibilité de détection souhaitée.

On se place dans le cas où le dispositif de test 15 utilisé est celui de la figure 2.

Si la tension cible Vc est inférieure (ici inférieure ou égale) au seuil prédéterminé, le procédé repasse à l'étape E2.

Si la tension cible est supérieure (ici strictement) au seuil prédéterminé, le microcontrôleur 16 détecte un niveau d'humidité trop élevé : étape E7.

Si le dispositif de test utilisé est celui de la figure 5, 6 ou 7, le niveau d'humidité trop élevé est détecté lorsque la tension cible est inférieure au seuil prédéterminé.

Le microcontrôleur génère une alarme (ou continue à la générer si une alarme a déjà été générée) qui alerte d'un potentiel risque de fiabilité du produit. Le microcontrôleur 16 comptabilise le nombre d'alarme déjà générée, en associant éventuellement chaque alarme avec un horodatage.

Cette alarme, avec ou sans ses infos complémentaires, peut être affichée sur l'écran du produit 1 ou être envoyée à l'utilisateur et/ou au gestionnaire du réseau et/ou au distributeur de fluide si le compteur est équipé d'un module de communication (LoRa, NB-IoT, W-Mbus, etc).

Cette alarme permet à l'utilisateur et/ou au gestionnaire du réseau et/ou au distributeur de fluide de prendre des mesures préventives pour assurer la durabilité et le bon fonctionnement du compteur.

Le procédé repasse à l'étape E2.

De nombreuses variantes sont envisageables.

Le circuit imprimé peut comprendre plusieurs premières pistes connectées en série, et plusieurs deuxièmes pistes connectées en série. Chaque ensemble d'une première piste et de la deuxième piste associée est positionné dans une zone distincte du circuit imprimé. Le niveau trop haut d'humidité est détecté lorsque les courants de fuite sont présents dans plusieurs zones à la fois.

De même, le circuit imprimé peut comprendre plusieurs premières pistes connectées en parallèle, et plusieurs deuxièmes pistes connectées en parallèle.

Les première piste 6a et deuxième piste 6b peuvent longer les bords du circuit imprimé 3.

La première piste et la deuxième piste peuvent être imprimées sur une même couche du circuit imprimé (qui peut être une couche interne), ou bien sur deux couches différentes. On mesure ainsi précisément l'humidité du circuit imprimé dans l'épaisseur de celui-ci entre les deux couches. Cette configuration ne fait pas partie de l'invention.

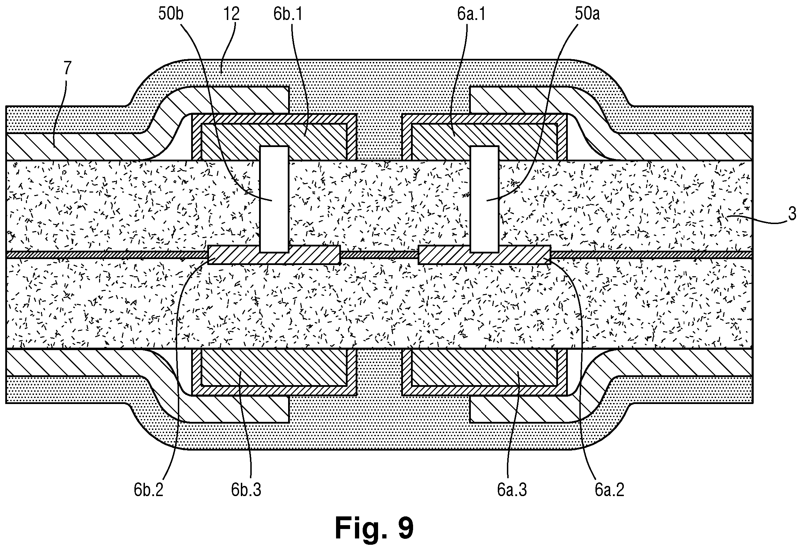

En référence à la figure 9, il est aussi possible d'avoir plusieurs premières pistes sur des couches distinctes et plusieurs deuxièmes pistes sur des couches distinctes.

Ici, on a deux premières pistes 6a.1, 6a.2 reliées par au moins un premier via traversant 50a, la première piste 6a.1 étant située sur une couche supérieure et la première piste 6a.2 sur une couche interne du circuit imprimé 3. On a aussi une deuxième piste 6b.1 et une deuxième piste 6b.2 reliées par au moins un deuxième via traversant 50b.

On a aussi une première piste 6a.3 et une deuxième piste 6b.3 sur la couche inférieure.

Dans le cas où la carte électrique comporte un ou des composants plus sensibles que les autres à l'humidité, on pourra positionner ce ou ces composants dans une zone entourée par la première piste 6a et la deuxième piste 6b.

Les composants les plus sensibles à l'humidité comprennent par exemple un ASIC, un quartz, etc.

Au cours de la conception de la carte électronique, on commencera donc pas définir le ou les composants les plus sensibles à l'humidité, puis on conçoit la première piste et la deuxième piste de sortes qu'elles entourent la zone dans laquelle ce ou ces composants sont situés. Par « les plus sensibles à l'humidité », on entend par exemple les composants qui présentent le taux de panne le plus élevé pour un niveau d'humidité donné.

La première piste et/ou la deuxième piste ne sont pas nécessairement dédiées à la détection d'humidité.

La première piste et/ou la deuxième piste peuvent être utilisées aussi pour transporter des signaux électriques quelconques (communication, commande, alimentation, etc.) utilisés pour une autre fonction quelconque.

La détection du niveau d'humidité trop élevé est réalisée lorsque ladite autre fonction est inactive.

L'invention présente les avantages suivants.

La détection d'humidité est efficace même en présence de résine. Contrairement aux capteurs d'humidité traditionnels (notamment ceux intégrés dans un boîtier CMS), le dispositif de surveillance fonctionne efficacement même lorsque le circuit imprimé est résiné ou vernis, offrant ainsi une solution plus fiable pour détecter l'humidité sur les cartes électroniques.

Le dispositif de surveillance a une faible consommation d'énergie. Il consomme nettement moins de courant que les méthodes capacitives traditionnelles, ce qui est particulièrement avantageux pour les applications à faible consommation d'énergie (exemple : compteur de fluide équipé de piles).

La détection d'humidité peut être activée à la demande ; mais il est aussi possible de laisser la fonction active constamment car la fuite de courant est très faible (et donc la consommation du dispositif est très faible).

Le dispositif de surveillance est très simple et a un coût réduit. Il utilise des électrodes simples et des mesures d'impédance DC (continue) pour détecter l'humidité, ce qui le rend moins complexe et moins coûteux que les capteurs CMS traditionnels.

Ces électrodes présentent une excellent adaptabilité. La forme des électrodes utilisées dans ce dispositif de surveillance du niveau d'humidité basé sur la mesure d'impédance DC peut être facilement adaptée pour cibler spécifiquement les zones du circuit imprimé présentant un risque accru d'humidité. Cette adaptabilité permet une détection plus précise et une meilleure détection de l'intégrité des zones critiques de la carte électronique.

Les électrodes peuvent être installées sur une face, sur les deux faces du circuit imprimé et éventuellement à l'intérieur dans une couche interne.

L'emplacement et la surface des électrodes peuvent être variables ; les électrodes peuvent être placées aux endroits les plus exposés ou les moins exposés.

La mesure du courant de fuite peut être complétée par des filtres (condensateur, inductance, transformateur de mode commun) afin de réduire les perturbations externes.

L'ouverture du vernis épargne permet de mesurer l'humidité au plus près des conducteurs électriques. La protection des conducteurs en cuivre par un revêtement (type or-nickel) est souhaitée pour éviter l'oxydation des conducteurs, mais n'est pas indispensable pour la fonction de mesure.

Le dispositif de surveillance peut être utilisé sur différents types de cartes électroniques, de matériaux et de configurations de circuit imprimé, offrant ainsi une solution polyvalente pour détecter l'humidité dans diverses applications électroniques.

Le dispositif de surveillance est très sensible. Il est capable de détecter des fuites de courant de l'ordre de 10 nA en présence de forte d'humidité/condensation, offrant une sensibilité élevée pour la détection de l'humidité sur les cartes électroniques.

Le dispositif de surveillance est moins sensible aux interférences et aux perturbations électromagnétiques que les capteurs CMS traditionnels, ce qui le rend plus robuste et fiable dans des environnements électroniques complexes.

Bien entendu, l'invention n'est pas limitée aux modes de réalisation décrits mais englobe toute variante entrant dans le champ de l'invention telle que définie par les revendications.

Comme on l'a vu, le dispositif de test applique une tension de test sur l'une des première piste conductrice et deuxième piste conductrice, l'autre des première piste conductrice et deuxième piste conductrice étant connectée à une référence de tension constante ou contrôlée. La deuxième piste peut ainsi être connectée à une masse électrique, éventuellement via un ou des composants, mais la référence de tension constante ou contrôlée n'est pas nécessairement le 0V présent sur la masse. Il peut s'agir par exemple d'une tension obtenue à partir d'une tension d'alimentation, ou bien produite par une source de tension.

Le dispositif de surveillance n'est pas nécessairement mis en œuvre dans un compteur de fluide, ni même dans un compteur, mais peut être intégré dans tout type d'équipement électrique.

Le composant de traitement du dispositif de test, dans lequel est mis en œuvre le procédé de détection, n'est pas forcément un microcontrôleur. Un autre composant pourrait être envisagé, par exemple un processeur « généraliste », un processeur spécialisé dans le traitement du signal (ou DSP, pour *Digital Signal Processor*), ou bien un circuit logique programmable tel qu'un FPGA (pour *Field Programmable Gate Arrays*) ou un ASIC (pour *Application Specific Integrated Circuit*).

Le composant de traitement du dispositif de test n'est pas nécessairement dédié à la surveillance de l'humidité, il pourrait être utilisé pour d'autres fonctions (métrologie par exemple).

Le comparateur utilisé pourrait être un comparateur différent, par exemple un trigger de Schmitt.

## Revendications

1. Dispositif de surveillance (5) de l'humidité sur un circuit imprimé (3) recouvert de vernis épargne sur une grande partie de ses couches externes, comportant :
- une première piste conductrice (6a) et une deuxième piste conductrice (6b) imprimées sur le circuit imprimé, et non connectées entre elles, la première piste conductrice (6a) comprenant une première portion de piste (8a) qui n'est pas recouverte de vernis épargne (7), le reste de la première piste conductrice étant recouvert de vernis épargne, et la deuxième piste conductrice (6b) comprenant une deuxième portion de piste (8b) qui n'est pas recouverte de vernis épargne, le reste de la deuxième piste conductrice étant recouvert de vernis épargne, la première portion de piste (8a) s'étendant sur un premier segment de la première piste conductrice (6a), et la deuxième portion de piste (8b) s'étendant sur un deuxième segment de la deuxième piste conductrice (6b), la première portion de piste (8a) étant définie sur toute la longueur et sur une partie interne de la largeur du premier segment, la deuxième portion de piste étant définie sur toute la longueur et sur une partie interne de la largeur du deuxième segment, la première portion de piste et la deuxième portion de piste étant donc disposées en regard l'une de l'autre, le premier segment et le deuxième segment se longeant sur le circuit imprimé (3), étant sensiblement parallèles et étant sensiblement de même longueur ;
- un dispositif de test (15) agencé pour :
∘ appliquer une tension de test (Vt) sur l'une des première piste conductrice et deuxième piste conductrice, l'autre des première piste conductrice et deuxième piste conductrice étant connectée à une référence de tension constante ou contrôlée (23) ;
∘ comparer une tension cible (Vc), représentative d'une impédance entre la première piste conductrice et la deuxième piste conductrice, avec un seuil prédéterminé (Sp), ladite impédance étant réduite en présence d'humidité ;
∘ détecter un niveau d'humidité trop élevé sur le circuit imprimé, entre la première piste conductrice et la deuxième piste conductrice, en fonction d'un résultat de ladite comparaison.

2. Dispositif de surveillance selon la revendication 1, dans lequel la tension de test (Vt) est une tension continue.

3. Dispositif de surveillance selon l'une des revendications précédentes, dans lequel la première portion de piste et la deuxième portion de piste sont recouvertes d'un revêtement de protection (11) destiné à empêcher un matériau principal, avec lequel sont fabriquées la première piste conductrice et la deuxième piste conductrice, de se corroder.

4. Dispositif de surveillance selon la revendication 3, le revêtement de protection étant en or-nickel.

5. Dispositif de surveillance selon l'une des revendications précédentes, dans lequel la première piste conductrice (6a) et la deuxième piste conductrice (6b) forment deux électrodes en forme de boucle.

6. Dispositif de surveillance selon l'une des revendications 1 à 4, dans lequel la première piste conductrice (6a) et la deuxième piste conductrice (6b) forment deux électrodes interdigitées.

7. Dispositif de surveillance selon l'une des revendications 1 à 4, dans lequel :
- la première piste conductrice (6a) est connectée à au moins une première castellation (35a, 36a, 27a, 28a) formée dans une épaisseur du circuit imprimé, et
- la deuxième piste conductrice (6b) est connectée à au moins une deuxième castellation (35b, 36b, 27b, 28b) formée dans l'épaisseur du circuit imprimé,
la tension de test étant appliquée sur la première piste conductrice et la tension cible étant mesurée sur la deuxième piste conductrice.

8. Dispositif de surveillance selon la revendication 7, dans lequel la première piste conductrice (6a) comporte deux premiers tronçons (24a) connectés entre eux, perpendiculaires entre eux et connectant chacun deux premières castellations (35a, 36a, 27a, 28a) entre elles, et la deuxième piste conductrice (6b) comporte deux deuxièmes tronçons (24b) connectés entre eux, perpendiculaires entre eux et connectant chacun deux deuxièmes castellations (35b, 36b, 27b, 28b) entre elles.

9. Dispositif de surveillance selon l'une des revendications précédentes, dans lequel la première piste conductrice et la deuxième piste conductrice sont situées sur une même couche du circuit imprimé.

10. Dispositif de surveillance selon la revendication 9, dans lequel ladite couche est une couche interne du circuit imprimé.

11. Dispositif de surveillance selon l'une des revendications précédentes, comprenant une première piste conductrice (6a.1) et une deuxième piste conductrice (6b.1) situées sur une première couche du circuit imprimée, et une autre première piste conductrice (6a.2) et une autre deuxième piste conductrice (6b.2) situées sur une deuxième couche du circuit imprimée, les premières pistes conductrices (6a.1, 6a.2) étant connectées entre elles par au moins un premier via traversant (50a) et les deuxièmes pistes conductrices (6b.1, 6b.2) étant connectées entre elles par au moins un deuxième via traversant (50b).

12. Dispositif de surveillance selon l'une des revendications précédentes, comprenant plusieurs premières pistes conductrices connectées en série et plusieurs deuxièmes pistes conductrices connectées en série.

13. Dispositif de surveillance selon l'une des revendications précédentes, comprenant plusieurs premières pistes conductrices connectées en parallèle et plusieurs deuxièmes pistes conductrices connectées en parallèle.

14. Dispositif de surveillance selon l'une des revendications précédentes, dans lequel la première piste conductrice et/ou la deuxième piste conductrice sont agencées pour transporter des signaux utilisés pour une autre fonction, le dispositif de surveillance étant agencé pour réaliser la détection du niveau d'humidité trop élevé lorsque ladite autre fonction est inactive.

15. Dispositif de surveillance selon l'une des revendications précédentes, dans lequel des composants électriques sont montés sur le circuit imprimé, ces composants électriques comportant un composant le plus sensible à l'humidité, le composant le plus sensible à l'humidité étant positionné dans une zone entourée par la première piste conductrice (6a) et la deuxième piste conductrice (6b).

16. Dispositif de surveillance selon l'une des revendications précédentes, comprenant un comparateur analogique (40) et une source de tension (41), la tension cible étant comparée par le comparateur analogique avec une tension de référence (Vref) produite par la source de tension, le seuil prédéterminé étant ainsi un seuil analogique.

17. Procédé de détection, mis en œuvre dans un dispositif de surveillance (5) selon l'une des revendications précédentes, comprenant les étapes de :
- appliquer une tension de test (Vt) sur l'une des première piste conductrice et deuxième piste conductrice, l'autre des première piste conductrice et deuxième piste conductrice étant connectée à une référence de tension constante ou contrôlée (23);
- comparer une tension cible (Vc), représentative d'une impédance entre la première piste conductrice et la deuxième piste conductrice, avec un seuil prédéterminé (Sp), ladite impédance étant réduite en présence d'humidité ;
- détecter un niveau d'humidité trop élevé sur le circuit imprimé, entre la première piste conductrice et la deuxième piste conductrice, en fonction d'un résultat de ladite comparaison.

18. Programme d'ordinateur comprenant des instructions qui conduisent le dispositif de test (15) du dispositif de surveillance selon l'une des revendications 1 à 16 à exécuter les étapes du procédé de détection selon la revendication 17.

19. Support d'enregistrement lisible par ordinateur, sur lequel est enregistré le programme d'ordinateur selon la revendication 18.

## Patentansprüche

1. Überwachungsvorrichtung (5) zur Überwachung der Feuchtigkeit auf einer Leiterplatte (3), deren äußere Lagen weitgehend mit Lötstopplack beschichtet sind, enthaltend:
- eine erste Leiterbahn (6a) und eine zweite Leiterbahn (6b), die auf die Leiterplatte aufgedruckt sind und nicht miteinander verbunden sind, wobei die erste Leiterbahn (6a) einen ersten Bahnabschnitt (8a) umfasst, der nicht mit Lötstopplack (7) beschichtet ist, wobei der Rest der ersten Leiterbahn mit Lötstopplack beschichtet ist, und wobei die zweite Leiterbahn (6b) einen zweiten Bahnabschnitt (8b) umfasst, der nicht mit Lötstopplack beschichtet ist, wobei der Rest der zweiten Leiterbahn mit Lötstopplack beschichtet ist, wobei sich der erste Bahnabschnitt (8a) über ein erstes Segment der ersten Leiterbahn (6a) hinweg erstreckt, und wobei sich der zweite Bahnabschnitt (8b) über ein zweites Segment der zweiten Leiterbahn (6b) hinweg erstreckt, wobei der erste Bahnabschnitt (8a) über die gesamte Länge und über einen Innenabschnitt der Breite des ersten Segments definiert ist, wobei der zweite Bahnabschnitt über die gesamte Länge und über einen Innenabschnitt der Breite des zweiten Segments definiert ist, wodurch der erste Bahnabschnitt und der zweite Bahnabschnitt einander gegenüberliegend angeordnet sind, wobei das erste Segment und das zweite Segment nebeneinander, im Wesentlichen parallel zueinander, auf der Leiterplatte (3) verlaufen und im Wesentlichen die gleiche Länge aufweisen;
- eine Testvorrichtung (15), die dafür ausgelegt ist:
∘ eine Testspannung (Vt) an eine aus der ersten Leiterbahn und der zweiten Leiterbahn anzulegen, wobei die jeweils andere aus der ersten Leiterbahn und der zweiten Leiterbahn mit einer konstanten oder geregelten Spannungsreferenz (23) verbunden ist;
∘ eine Zielspannung (Vc), die eine Impedanz zwischen der ersten Leiterbahn und der zweiten Leiterbahn darstellt, mit einem vorbestimmten Schwellenwert (Sp) zu vergleichen, wobei die Impedanz bei Vorhandensein von Feuchtigkeit vermindert ist;
∘ in Abhängigkeit von einem Ergebnis dieses Vergleichs ein zu hohes Feuchtigkeitsniveau auf der Leiterplatte zwischen der ersten Leiterbahn und der zweiten Leiterbahn zu erkennen.

2. Überwachungsvorrichtung nach Anspruch 1, wobei es sich bei der Testspannung (Vt) um eine Gleichspannung handelt.

3. Überwachungsvorrichtung nach einem der vorhergehenden Ansprüche, wobei der erste Bahnabschnitt und der zweite Bahnabschnitt mit einer Schutzbeschichtung (11) überzogen sind, die dazu dient, die Korrosion eines Hauptmaterials, aus welchem die erste Leiterbahn und die zweite Leiterbahn hergestellt sind, zu verhindern.

4. Überwachungsvorrichtung nach Anspruch 3, wobei die Schutzbeschichtung aus Gold-Nickel besteht.

5. Überwachungsvorrichtung nach einem der vorhergehenden Ansprüche, wobei die erste Leiterbahn (6a) und die zweite Leiterbahn (6b) zwei Schleifenelektroden bilden.

6. Überwachungsvorrichtung nach einem der Ansprüche 1 bis 4, wobei die erste Leiterbahn (6a) und die zweite Leiterbahn (6b) zwei Interdigitalelektroden bilden.

7. Überwachungsvorrichtung nach einem der Ansprüche 1 bis 4, wobei:
- die erste Leiterbahn (6a) mit zumindest einer in einer Leiterplattendicke ausgebildeten ersten Kastellierung (35a, 36a, 27a, 28a) verbunden ist, und
- die zweite Leiterbahn (6b) mit zumindest einer in einer Leiterplattendicke ausgebildeten zweiten Kastellierung (35b, 36b, 27b, 28b) verbunden ist,
wobei die Testspannung an die erste Leiterbahn angelegt wird und die Zielspannung an der zweiten Leiterbahn gemessen wird.

8. Überwachungsvorrichtung nach Anspruch 7, wobei die erste Leiterbahn (6a) zwei erste miteinander verbundene Abschnitte (24a) enthält, welche senkrecht zueinander verlaufen und jeweils zwei erste Kastellierungen (35a, 36a, 27a, 28a) miteinander verbinden, und wobei die zweite Leiterbahn (6b) zwei zweite miteinander verbundene Abschnitte (24b) enthält, welche senkrecht zueinander verlaufen und jeweils zwei zweite Kastellierungen (35b, 36b, 27b, 28b) miteinander verbinden.

9. Überwachungsvorrichtung nach einem der vorhergehenden Ansprüche, wobei sich die erste Leiterbahn und die zweite Leiterbahn auf ein und derselben Lage der Leiterplatte befinden.

10. Überwachungsvorrichtung nach Anspruch 9, wobei es sich bei besagter Lage um eine Innenlage der Leiterplatte handelt.

11. Überwachungsvorrichtung nach einem der vorhergehenden Ansprüche, umfassend eine erste Leiterbahn (6a.1) und eine zweite Leiterbahn (6b.1), die sich auf einer ersten Lage der Leiterplatte befinden, sowie eine weitere erste Leiterbahn (6a.2) und eine weitere zweite Leiterbahn (6b.2), die sich auf einer zweiten Lage der Leiterplatte befinden, wobei die ersten Leiterbahnen (6a.1, 6a.2) über zumindest eine erste Durchkontaktierung (50a) miteinander verbunden sind, und die zweiten Leiterbahnen (6b.1, 6b.2) über zumindest eine zweite Durchkontaktierung (50b) miteinander verbunden sind.

12. Überwachungsvorrichtung nach einem der vorhergehenden Ansprüche, umfassend mehrere in Reihe geschaltete erste Leiterbahnen und mehrere in Reihe geschaltete zweite Leiterbahnen.

13. Überwachungsvorrichtung nach einem der vorhergehenden Ansprüche, umfassend mehrere parallel geschaltete erste Leiterbahnen und mehrere parallel geschaltete zweite Leiterbahnen.

14. Überwachungsvorrichtung nach einem der vorhergehenden Ansprüche, wobei die erste Leiterbahn und/oder die zweite Leiterbahn dafür ausgelegt sind, Signale zu übertragen, die für eine andere Funktion verwendet werden, wobei die Überwachungsvorrichtung dafür ausgelegt ist, die Erkennung des zu hohen Feuchtigkeitsniveaus dann durchzuführen, wenn besagte andere Funktion inaktiv ist.

15. Überwachungsvorrichtung nach einem der vorhergehenden Ansprüche, wobei elektrische Komponenten auf der Leiterplatte montiert sind, wobei diese elektrischen Komponenten eine am stärksten feuchtigkeitsempfindliche Komponente enthalten, wobei die am stärksten feuchtigkeitsempfindliche Komponente in einem Bereich positioniert ist, der von der ersten Leiterbahn (6a) und von der zweiten Leiterbahn (6b) umgeben ist.

16. Überwachungsvorrichtung nach einem der vorhergehenden Ansprüche, umfassend einen analogen Komparator (40) und eine Spannungsquelle (41), wobei die Zielspannung von dem analogen Komparator mit einer von der Spannungsquelle erzeugten Referenzspannung (Vref) verglichen wird, sodass der vorbestimmte Schwellenwert ein analoger Schwellenwert ist.

17. Detektionsverfahren, welches in einer Überwachungsvorrichtung (5) nach einem der vorhergehenden Ansprüche ausgeführt wird und die Schritte umfasst, dass:
- eine Testspannung (Vt) an eine aus der ersten Leiterbahn und der zweiten Leiterbahn angelegt wird, wobei die jeweils andere aus der ersten Leiterbahn und der zweiten Leiterbahn mit einer konstanten oder geregelten Spannungsreferenz (23) verbunden ist;
- eine Zielspannung (Vc), die eine Impedanz zwischen der ersten Leiterbahn und der zweiten Leiterbahn darstellt, mit einem vorbestimmten Schwellenwert (Sp) verglichen wird, wobei die Impedanz bei Vorhandensein von Feuchtigkeit vermindert ist;
- in Abhängigkeit von einem Ergebnis dieses Vergleichs ein zu hohes Feuchtigkeitsniveau auf der Leiterplatte zwischen der ersten Leiterbahn und der zweiten Leiterbahn erkannt wird.

18. Computerprogramm, das Befehle umfasst, welche die Testvorrichtung (15) der Überwachungsvorrichtung nach einem der Ansprüche 1 bis 16 dazu veranlassen, die Schritte des Detektionsverfahrens nach Anspruch 17 auszuführen.

19. Computerlesbares Speichermedium, auf welchem das Computerprogramm nach Anspruch 18 abgespeichert ist.

## Claims

1. Device (5) for monitoring humidity on a printed circuit (3) covered with solder mask over a large part of its external layers, comprising:
- a first conductive track (6a) and a second conductive track (6b) printed on the printed circuit, and not connected to one another, the first conductive track (6a) comprising a first track portion (8a) which is not covered with solder mask (7), the rest of the first conductive track being covered with solder mask, and the second conductive track (6b) comprising a second track portion (8b) which is not covered with solder mask, the rest of the second conductive track being covered with solder mask, the first track portion extending over a first segment of the first conductive track, and the second track portion extending over a second segment of the second conductive track, the first track portion being defined over the entire length and on an internal part of the width of the first segment, the second track portion being defined over the entire length and on an internal part of the width of the second segment, the first track portion and the second track portion being therefore disposed facing one another, the first segment and the second segment going along over the printed circuit, being substantially parallel and being substantially of the same length ;
- a test device (15) arranged to:
∘ apply a test voltage (Vt) on one of the first conductive track and second conductive track, the other of the first conductive track and second conductive track being connected to a constant or controlled voltage reference (23);
∘ compare a target voltage (Vc), representative of an impedance between the first conductive track and the second conductive track, with a predetermined threshold (Sp), said impedance being reduced in the presence of humidity;
∘ detect a humidity level which is too high on or in the printed circuit, between the first conductive track and the second conductive track, according to a result of said comparison.

2. Monitoring device according to claim 1, wherein the test voltage (Vt) is a direct voltage.

3. Monitoring device according to any one of the preceding claims, wherein the first track portion and the second track portion are covered with a protective coating (11) intended to prevent a main material, with which the first conductive track and the second conductive track are manufactured, from corroding.

4. Monitoring device according to claim 4, the protective coating being made of gold-nickel.

5. Monitoring device according to any one of the preceding claims, wherein the first conductive track (6a) and the second conductive track (6b) form two loop-shaped electrodes.

6. Monitoring device according to any one of claims 1 to 4, wherein the first conductive track (6a) and the second conductive track (6b) form two interdigitated electrodes.

7. Monitoring device according to any one of claims 1 to 4, wherein:
- the first conductive track (6a) is connected to at least one first castellation (25a, 26a, 27a, 28a) formed in a thickness of the printed circuit, and
- the second conductive track (6b) is connected to at least one second castellation (25b, 26b, 27b, 28b) formed in the thickness of the printed circuit,
the test voltage being applied on the first conductive track and the target voltage being measured on the second conductive track.

8. Monitoring device according to claim 7, wherein the first conductive track (6a) comprises two first sections (24a) connected to one another, perpendicular to one another and each connecting two first castellations (25a, 26a, 27a, 28a) to one another, and the second conductive track (6b) comprises two second sections (24b) connected to one another, perpendicular to one another and each connecting two second castellations (25b, 26b, 27b, 28b) to one another.

9. Monitoring device according to any one of the preceding claims, wherein the first conductive track and the second conductive track are located on one same layer of the printed circuit.

10. Monitoring device according to claim 9, wherein said layer is an internal layer of the printed circuit.

11. Monitoring device according to any one of the preceding claims, comprising a first conductive track (6a.1) and a second conductive track (6b.1) located on a first layer of the printed circuit, and another first conductive track (6a.2) and another second conductive track (6b.2) located on a second layer of the printed circuit, the first conductive tracks (6a.1, 6a.2) being connected to one another by at least one first through via (50a) and the second conductive tracks (6b.1, 6b.2) being connected to one another by at least one second through via (50b).

12. Monitoring device according to any one of the preceding claims, comprising several first conductive tracks connected in series and several second conductive tracks connected in series.

13. Monitoring device according to any one of the preceding claims, comprising several first conductive tracks connected in parallel and several second conductive tracks connected in parallel.

14. Monitoring device according to any one of the preceding claims, wherein the first conductive track and/or the second conductive track are arranged for transporting signals used for another function, the monitoring device being arranged to perform the detection of the humidity level which is too high when said other function is inactive.

15. Monitoring device according to any one of the preceding claims, wherein electrical components are mounted on the printed circuit, these electrical components comprising a component which is the most sensitive to humidity, the component which is the most sensitive to humidity being positioned in a zone surrounded by the first conductive track (6a) and the second conductive track (6b).

16. Monitoring device according to any one of the preceding claims, comprising an analogue comparator (40) and a voltage source (41), the target voltage being compared by the analogue comparator with a reference voltage (Vref) produced by the voltage source, the predetermined threshold thus being an analogue threshold.

17. Detection method, implemented in a monitoring device (5) according to any one of the preceding claims, comprising the steps of:
- applying a test voltage (Vt) on one of the first conductive track and second conductive track, the other of the first conductive track and second conductive track being connected to a constant or controlled voltage reference (23);
- comparing a target voltage (Vc), representative of an impedance between the first conductive track and the second conductive track, with a predetermined threshold (Sp), said impedance being reduced in the presence of humidity;
- detecting a humidity level which is too high on or in the printed circuit, between the first conductive track and the second conductive track, according to a result of said comparison.

18. Computer program comprising instructions which cause the test device (15) of the monitoring device according to one of claims 1 to 16 to execute the steps of the detection method according to claim 17.

19. Recording medium which can be read by a computer, on which the computer program is recorded according to claim 18.
